Europäisches Patentamt

European Patent Office

Office européen des brevets

(11) Veröffentlichungsnummer: **0 519 262 A1**

## EUROPÄISCHE PATENTANMELDUNG

(21) Anmeldenummer: **92109302.7**

(22) Anmeldetag: **02.06.92**

(51) Int. Cl.5: **C25D 13/22**, C25D 13/16

(30) Priorität: **21.06.91 DE 4120575**

(43) Veröffentlichungstag der Anmeldung:
**23.12.92 Patentblatt 92/52**

(84) Benannte Vertragsstaaten:
**AT BE CH DE FR GB IT LI NL SE**

(71) Anmelder: **SIEMENS AKTIENGESELLSCHAFT**
**Wittelsbacherplatz 2**
**W-8000 München 2(DE)**

(72) Erfinder: **Hosten, Daniel**
**Staatsbaan 147**
**B-8610 Handzame, (Kortemark)(BE)**

(54) **Einrichtung zum elektrophoretischen Auftrag eines Lackes auf plattenförmige Werkstoffe.**

(57) Zum elektrophoretischen Auftrag eines Lackes auf plattenförmige Werkstücke (W) wurden diese auf einer horizontalen Durchlaufbahn (D) durch eine Zelle (Z) transportiert, in welcher sich ein Lackabscheidungsbad und mindestens eine Elektrode befinden. Die anodische oder kathodische Kontaktierung der durchlaufenden Werkstücke (W) erfolgt über einen vorzugsweise durch ein Metallband gebildeten endlos umlaufenden Kontaktiertrieb (K) und ein außerhalb der Zelle (Z) angeordnetes Kontaktorgan (Ko) für die Zufuhr des Anodenstroms oder Kathodenstroms zum Kontaktiertrieb (K). Über eine außerhalb der Zelle (Z) angeordnete Reinigungseinrichtung (R1, R2, R3, R4) wird der in der Zelle (Z) auf dem Kontaktiertrieb (K) abgeschiedene Lack wieder entfernt und damit eine sichere Kontaktierung der Werkstücke (W) gewährleistet. Die erfindungsgemäße Einrichtung eignet sich insbesondere zum elektrophoretischen Auftrag von Ätzresists, Plating Resists und Solder Resists auf Leiterplatten.

FIG1

Beim Aufbau von gedruckten Schaltungen bzw. Leiterplatten unterscheidet man grundsätzlich die weit verbreitete Subtraktivtechnik, die von metallkaschierten Substraten bzw. Basismaterialien ausgeht und das nicht für Leiterzüge benötigte Kupfer durch Ätzung entfernt, von der Additivtechnik, die auf haftvermittlerbeschichteten Substraten aufbauend, das Leiterbahnmaterial nur dort aus Bädern aufbringt, wo Leiterzüge benötigt werden. Auch Kombinationen dieser Verfahren sind üblich. Bei sämtlichen Varianten wird dabei das eigentliche Leiterbild photolithographisch durch Aufbringen, Belichten und Entwickeln von Photoresistschichten erzeugt. Bei den herkömmlichen lichtempfindlichen Photoresistschichten, bei welchen es sich je nach der angewandten Technik um Plating Resists oder Ätzresists handeln kann, erfolgt das Aufbringen des flüssigen Resistmaterials durch Tauchen, Aufwalzen oder Schleuderbeschichten. Es ist aber auch möglich, das Resistmaterial in Form eines sog. Trockenfilmresists unter Anwendung einer geeigneten Klebevorrichtung aufzulaminieren.

Aus der DE-A-36 28 340 ist auch bereits ein Verfahren zur Herstellung von Leiterplatten mit den gewünschten Leiterzügen unter Anwendung eines auf einer Oberfläche eines kupferplattierten isolierenden Substrats aufgebrachten lichtempfindlichen Resistfilms bekannt, welches darin besteht, daß man den lichtempfindlichen Resistfilm galvanisch durch Eintauchen des isolierenden Substrats in ein wasserlösliche oder in Wasser dispergierbare, unter Lichteinwirkung aushärtende Kunststoffe als Hauptbestandteile enthaltendes Lackabscheidungsbad unter Anwendung von Gleichstrom auf der Oberfläche des kupferplattierten Substrats abscheidet. Das strukturierbare Resist wird hier also elektrophoretisch aufgebracht, wobei eine derartige Aufbringung beim Einsatz in der industrieellen Serienlackierung häufig auch als anodische oder kathodische Elektrotauchlackierung bezeichnet wird. Das elektrophoretische Auftragen des lichtempfindlichen Resistfilms erfolgt in einem das Lackabscheidungsbad aufnehmenden Behälter, in welchen von oben her die zu beschichtende Leiterplatte und zwei im Abstand zur Leiterplatte angeordnete plattenförmige Elektroden eingehängt werden.

Aus der EP-A-0 370 133 ist es auch bereits bekannt, neben Ätzresists und Plating Resists auch Solder Resists elektrophoretisch auf Leiterplatten aufzubringen.

Bei der industriellen Fertigung von Leiterplatten muß der elektrische Auftrag eines als Ätzresist, Plating Resist oder Solder Resist dienenden Lackes im Durchlaufverfahren vorgenommen werden können, wobei auch hier ebenso wie bei den entsprechenden Galvanisiereinrichtungen sog. Horizontal-Durchlaufanlagen einen besonders wirtschaftlichen Einsatz ermöglichen. Die bekannten, als Horizontal-Durchlaufanlagen ausgebildeten Galvanisiereinrichtungen für Leiterplatten (vgl. EP-A-0 254 962 oder DE-A-36 24 481) können jedoch nicht zum elektrophoretischen Auftrag eines Lackes verwendet werden, da die elektrophoretisch abgeschiedenen Lackschichten im Gegensatz zu galvanisch abgeschiedenen Metallschichten einen hohen spezifischen Widerstand aufweisen und durch ihre nicht zu verhindernde Abscheidung auf den umlaufenden Kontaktorganen bereits nach kurzer Zeit eine sichere Kontaktierung der Leiterplatten verhindern.

Der im Anspruch 1 angegebenen Erfindung liegt das Problem zugrunde, beim elektrophoretischen Auftrag eines Lackes auf plattenförmige Werkstücke in einer Horizontal-Durchlaufanlage eine einwandfreie anodische oder kathodische Kontaktierung der Werkstücke zu gewährleisten.

Die mit der Erfindung erzielten Vorteile bestehen insbesondere darin, daß durch die Verwendung eines endlos umlaufenden Kontaktiertriebes der im Lackabscheidungsbad auf diesem Kontaktiertrieb abgeschiedene Lack außerhalb des Bades wieder entfernt werden kann und daß auch die Stromzufuhr zum Kontaktiertrieb ohne Beeinträchtigung durch Lackabscheidungen außerhalb des Bades vorgenommen werden kann. Somit ist stets eine sichere anodische oder kathodische Kontaktierung der durchlaufenden Werkstücke durch den vor dem Wiedereintritt in das Lackabscheidungsbad frisch gereinigten Kontaktiertrieb gewährleistet.

Vorteilhafte Ausgestaltungen der Erfindung sind in den Ansprüchen 2 bis 21 angegeben.

Die Weiterbildung gemäß Anspruch 2 gewährleistet durch die Umwälzung der Badflüssigkeit gleichbleibend günstige Abscheidungsbedingungen. Dabei ist es besonders günstig, gemäß Anspruch 3 in den Kreislauf einen außerhalb der Zelle angeordneten Badflüssigkeitsbehälter einzubeziehen. Eine weitere Verbesserung der Abscheidungsbedingungen kann dann gemäß Anspruch 4 dadurch erzielt werden, daß die Badflüssigkeit aus dem Badflüssigkeitsbehälter separat in den oberhalb der Durchlaufbahn liegenden Bereich der Zelle und den unterhalb der Durchlaufbahn liegenden Bereich der Zelle zurückgeführt wird.

Die Weiterbildung nach Anspruch 5 ermöglicht die Entfernung eines sich auf der abgeschiedenen Lackschicht befindlichen Films der Badflüssigkeit.

Die Ausgestaltung nach Anspruch 6 bietet die Möglichkeit, die Zelle vollständig abzuschließen, wobei der Deckel für Wartungszwecke und dgl. jedoch auch wieder aufgeklappt werden kann.

Die Ausgestaltung nach Anspruch 7 ermöglicht vollständig gleichmäßige Abscheidungsbedingungen auf der Oberseite und der Unterseite der durchlaufenden Werkstücke.

Die Ausgestaltung nach Anspruch 8 ermöglicht die Einsparung einer separaten Transporteinrichtung für die Werkstücke.

Sind gemäß Anspruch 9 zu beiden Seiten der Durchlaufbahn Kontaktiertriebe angeordnet, so wird hierdurch die anodische oder kathodische Kontaktierung der durchlaufenden Werkstücke weiter verbessert und gleichzeitig eine sichere Führung der durchlaufenden Werkstücke gewährleistet.

Die Weiterbildung nach Anspruch 10 ermöglicht eine besonders einfache und wirtschaftliche Ausbildung des Kontaktiertriebes.

Die Ausgestaltung nach Anspruch 11 ermöglicht eine besonders einfache Führung des Kontaktiertriebes im Bereich der Zeile.

Die Weiterbildung nach Anspruch 12 ermöglicht eine weitere Verbesserung der anodischen oder kathodischen Kontaktierung der durchlaufenden Werkstücke. Dabei ist es besonders günstig, wenn gemäß Anspruch 13 die durchlaufenden Werkstücke über Andruckrollen gegen den Kontaktiertrieb gedrückt werden. Diese Andruckrollen können dann gemäß Anspruch 14 derart schräg angestellt werden, daß ein Durchbiegen dünner Werkstücke verhindert wird. Gemäß Anspruch 15 können diese Andruckrollen dann auch mit verhältnismäßig geringem Aufwand zur Bildung einer zusätzlichen Transporteinrichtung angetrieben werden.

Die Ausgestaltung nach Anspruch 16 ermöglicht eine besonders einfache und zuverlässige Zufuhr des Anodenstroms oder Kathodenstroms zu dem Kontaktiertrieb.

Die Ausgestaltung nach Anspruch 17 betrifft die besonders wirkungsvolle chemische Entlackung des Kontaktiertriebes, wobei diese chemische Entlackung allein oder auch zusätzlich zu einer mechanischen Entlackung durch Abstreifer oder Bürsten vorgenommen werden kann. Gemäß Anspruch 18 ist diese chemische Entlackung dann besonders wirkungsvoll, wenn das Entlackungsmittel mit Hilfe von Sprühdüsen auf den Kontaktiertrieb gesprüht wird.

Die Weiterbildung nach Anspruch 19 verhindert mit Sicherheit, daß Reste des chemischen Entlackungsmittels in das Lackabscheidungsbad gelangen. Gemäß Anspruch 20 ist es auch hier wiederum besonders günstig, wenn der Spülvorgang mit Hilfe von Sprühdüsen vorgenommen wird.

Die Ausgestaltung nach Anspruch 21 bietet schließlich die Möglichkeit, die Verweildauer des Kontaktiertriebes im Bereich der Reinigungseinrichtung auf einfache Weise zu verlängern und hierdurch eine besonders effektive Reinigung des Kontaktiertriebes zu gewährleisten.

Ein Ausführungsbeispiel in der Erfindung ist in der Zeichnung dargestellt und wird im folgenden näher beschrieben.

Es zeigen

Fig. 1 einen Längsschnitt durch eine Einrichtung zum elektrophoretischen Auftrag eines Lackes auf Leiterplatten in stark vereinfachter schematischer Darstellung und

Fig. 2 einen teilweisen Querschnitt durch eine entsprechend dem in Fig. 1 dargestellten Prinzip aufgebaute Einrichtung.

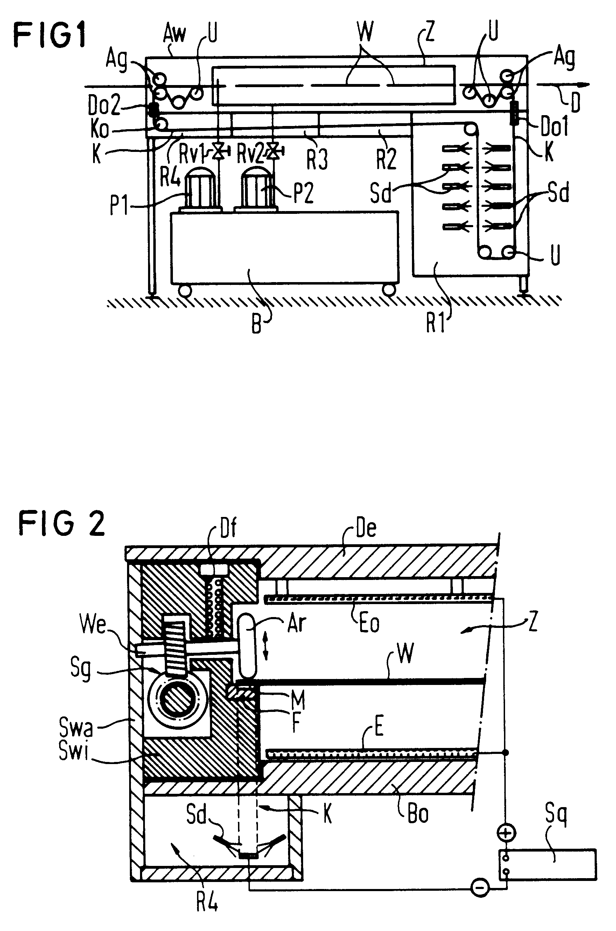

Gemäß Fig. 1 werden die als plattenförmige Werkstücke W bezeichneten Leiterplatten in horizontaler Lage und auf einer horizontalen Durchlaufbahn D durch eine bis auf die erforderlichen Ein- und Austrittsschlitze geschlossene Zelle Z transportiert, in welcher sich ein nicht näher bezeichnetes Lackabscheidungsbad befindet. Zur Umwälzung der Badflüssigkeit befindet sich unterhalb der Zelle Z ein Badflüssigkeitsbehälter B, aus welchem über Pumpen P1 und P2 sowie Regelventile Rv1 und Rv2 die Bereiche der Zelle Z ober- und unterhalb der Durchlaufbahn D separat mit Badflüssigkeit beaufschlagt werden. Die Rückführung der Badflüssigkeit aus der Zelle Z bzw. aus einer unterhalb der Zelle Z angeordneten Auffangwanne Aw in den Badflüssigkeitsbehälter B ist in Fig. 1 nicht näher dargestellt. Einlaufseitig vor der Zelle Z und auslaufseitig nach der Zelle Z befindet sich innerhalb der Auffangwanne Aw jeweils ein Paar von mit Aq bezeichneten Abquetschwalzen.

Die durch die Zelle Z transportierten plattenförmigen Werkstücke W müssen je nach Art des verwendeten Lackabscheidungsbades entweder anodisch oder kathodisch kontaktiert werden. Diese Kontaktierung wird über beidseitig der Durchlaufbahn D angeordnete, endlos umlaufende Kontaktiertriebe K vorgenommen, auf welchen die seitlichen Randbereiche der plattenförmigen Werkstücke W aufliegen.

In der Prinzipdarstellung der Fig. 1 ist deutlich zu erkennen, daß die endlos umlaufenden Kontaktiertriebe K über die bereits erwähnten Abquetschwalzen Aq und eine größere Anzahl von Umlenkrollen U derart geführt sind, daß sie im Bereich der Zelle Z genau in Richtung der Durchlaufbahn D verlaufen, nach den ausgangsseitigen Abquetschwalzen Aq über ein erstes Dichtorgan Do1 in eine erste Reinigungseinrichtung R1 eintreten, daran anschließend eine zweite Reinigungseinrichtung R2, eine dritte Reinigungseinrichtung R3 und eine vierte Reinigungseinrichtung R4 durchlaufen und dann über ein zweites Dichtorgan Do2 und die eingangsseitigen Abquetschwalten Aq wieder in die Zelle Z eintreten. Die Zufuhr des Anodenstroms oder Kathodenstroms erfolgt über ein als Kontaktrolle oder Kontaktwalze ausgebildetes Kontaktorgan Ko, welches beispielsweise aus CrNi 18.10 besteht und in Umlaufrichtung gesehen unmittelbar vor dem zweiten Dichtorgan Do2 angeordnet ist. Das Kontaktorgan Ko ist auch mit einem in Fig. 1 nicht näher erkennbaren Antriebsmotor verbunden, um die Kontaktiertriebe K anzutreiben und damit auch die plattenförmigen Werkstücke W durch die Zelle Z zu transportieren.

Die Reinigungseinrichtung R1 ist für die chemische Entfernung des in der Zelle Z auf dem Kontaktiertrieb K abgeschiedenen Lackes vorgesehen. Hierzu wird der Kontaktiertrieb K innerhalb der Reinigungseinrichtung R mäanderförmig umgelenkt, so daß er von beiden Seiten her über mehrere nacheinander angeorndete Sprühdüsen Sd mit dem entsprechenden chemischen Entlackungsmittel, beispielsweise mit Schwefelsäure, beaufschlagt werden kann. Nach dieser chemischen Entlackung werden Reste des Entlackungsmittels in den unterhalb der Auffangwanne Aw nacheinander angeordneten Reinigungseinrichtungen R2, R3 und R4 mit Hilfe von Wasser abgespült. Auf diese Weise ist sichergestellt, daß der Kontaktiertrieb K im Bereich des Kontaktorgans Ko und beim Wiedereintritt in die Zelle Z sowohl von dem abgeschiedenen Lack als auch von dem hierzu verwendeten chemischen Entlackungsmittel vollständig befreit ist. Durch den metallisch blanken Kontaktiertrieb K ist dann eine einwandfreie anodische oder kathodische Kontaktierung der durchlaufenden plattenförmigen Werkstücke W gewährleistet.

Fig. 2 zeigt einen Querschnitt durch den in Durchlaufrichtung gesehen linken Bereich einer gemäß dem in Fig. 1 dargestellten Prinzip aufgebauten Einrichtung zum elektrophoretischen Auftrag eines Lackes auf Leiterplatten bzw. plattenförmige Werkstücke W. Der nicht dargestellte rechte Teil dieser Einrichtung ist genau spiegelbildlich zum linken Teil aufgebaut. Es ist zu erkennen, daß die Zelle Z durch innere Seitenwände Swi, äußere Seitenwände Swa, einen aufklappbaren Deckel De und einen festen Boden Bo gebildet ist, wobei alle diese Teile aus elektrisch isolierendem Material wie z. B. PVC, PE oder PP bestehen. In Fig. 2 sind ferner eine am Deckel De aufgehängte obere Elektrode Eo und eine am Boden Bo befestigte untere Elektrode Eu zu erkennen, die beide horizontal ausgerichtet sind und beispielsweise aus CrNi 18.10 oder aus Titan bestehen. Im dargestellten Ausführungsbeispiel sind die Elektroden Eo und Eu als Anoden an den Pluspol einer schematisch dargestellten Stromquelle Sq angeschlossen, deren Minuspol über nicht näher dargestelle Kontaktorgane wie Kontaktrollen, Kontaktwalzen oder auch Kontaktbürsten mit dem hier durch ein Metallband M gebildeten Kontaktiertrieb K verbunden ist. Dieses beispielsweise aus CrNi 18.10 bestehende flexible Metallband M ist beispielsweise 10 mm breit und 0,5 mm stark. Die Führung des Metallbandes M innerhalb der Zelle Z erfolgt über eine als Leiste ausgebildete und mit der inneren Seitenwand Swi verbundene horizontale Führung F, die zur Gewährleistung guter Gleiteigenschaften beispielsweise auch hochmolekularem PE besteht.

Die innerhalb der Zelle Z mit ihren seitlichen Randbereichen auf den Metallbändern M aufliegenden plattenförmigen Werkstücke W werden über mehrere in Durchlaufrichtung nacheinander angeordnete Andruckrollen Ar aus elektrisch isolierendem Material gegen die Metallbänder M und die Führungen F gedrückt. Die Andruckkraft wird über Druckfedern Df erzeugt, die in nicht näher bezeichneten Bohrungen der inneren Seitenwände Swi angeordnet sind und auf die schräg angestellten Welle We der Andruckrollen Ar einwirken. Durch diese schräge Anstellung wird bei dünnen Werkstücken W, insbesondere bei den flexiblen Innenlagen von Leiterplatten, ein Durchbiegen innerhalb der Zelle Z zumindest weitgehend verhindert. Zur Bildung eines zusätzlichen Antriebs für die Werkstücke W sind die Wellen We der Andruckrollen Ar über Schneckengetriebe Sg angetrieben, die in nicht näher bezeichneten Ausnehmungen der inneren Seitenwände Swi angeordnet sind und aus elektrisch isolierendem Material bestehen.

Der in Fig. 2 dargestllte Querschnitt zeigt auch die Anordnung einer bereits im Zusammenhang mit Fig. 1 erwähnten vierten Reinigungseinrichtung R4 unterhalb der Zelle Z. Es ist ferner zu erkennen, daß auch innerhalb dieser Reinigungseinrichtung R4 Sprühdüsen Sd zum Spülen des Kontaktiertriebes K verwendet werden.

Alternativ zu den in Fig. 2 dargestellten Andruckrollen Ar könnten die plattenförmigen Werkstücke W auch zwischen zwei Metallbändern geführt werden. Zur Erzeugung einer Andruckkraft könnte dann das obere Metallband auf einer entsprechend abgefederten Führung gleiten.

Die im Zusammenhang mit den Fig. 1 und 2 beschriebene Einrichtung kann zum elektrophoretischen Auftrag von Ätzresist, Plating Resist und Solder Resist auf Leiterplatten eingesetzt werden, wobei sowohl eine anodische als auch eine kathodische Elektrotauchlackierung möglich sind. Ein für den Auftrag von Plating Resists auf Leiterplatten geeignetes Lackabscheidungsbad wird beispielsweise von der Firma Shiply unter dem Handelsnamen "Eagle" vertrieben.

**Patentansprüche**

1. Einrichtung zum elektrophoretischen Auftrag eines Lackes auf plattenförmige Werkstücke (W), insbesondere auf Leiterplatten, mit
   - einer Zelle (Z) zur Aufnahme eines Lackabscheidungsbades,
   - mindestens einer in der Zelle (Z) angeordneten Elektrode (Eo, Eu) mit der entgegengesetzten Polarität der anodisch

oder kathodisch kontaktierten Werkstük-ke (W),

- einer Transporteinrichtung für den Transport der Werkstücke (W) durch die Zelle (Z) auf einer horizontalen Durchlaufbahn (D),

- mindestens einem im Bereich der Zelle (Z) synchron mit den Werkstücken (W) umlaufenden endlosen Kontaktiertrieb (K) zur anodischen oder kathodischen Kontaktierung der durchlaufenden Werkstücke (W),

- mindestens einem außerhalb der Zelle (Z) angeordneten Kontaktorgan (Ko) für die Zufuhr des Anodenstroms oder Kathodenstroms zu dem Kontaktiertrieb (K) und mit

- mindestens einer außerhalb der Zelle (Z) angeordneten Reinigungseinrichtung (R1, R2, R3, R4) zur Entfernung des in der Zelle (Z) auf dem Kontaktiertrieb (K) abgeschiedenen Lackes.

2. Einrichtung nach Anspruch 1,
   **dadurch gekennzeichnet,**
   daß die Badflüssigkeit im Kreislauf umgewälzt wird.

3. Einrichtung nach Anspruch 2,
   **dadurch gekennzeichnet**
   daß die Badflüssigkeit im Kreislauf mit einem außerhalb der Zelle (Z) angeordneten Badflüssigkeitsbehälter (B) umgewälzt wird.

4. Einrichtung nach Anspruch 3,
   **dadurch gekennzeichnet,**
   daß die Badflüssigkeit aus dem Badflüssigkeitsbehälter (B) separat in den oberhalb der Durchlaufbahn (D) liegenden Bereich der Zelle (Z) und den unterhalb der Durchlaufbahn (D) liegenden Bereich der Zelle (Z) zurückgeführt wird.

5. Einrichtung nach einem der vorhergehenden Ansprüche,
   **gekennzeichnet durch**
   die auslaufseitige Anordnung von Abquetschwalzen (Aq).

6. Einrichtung nach einem der vorhergehenden Ansprüche,
   **dadurch gekennzeichnet,**
   daß die Zelle (Z) durch einen Deckel (De) verschließbar ist.

7. Einrichtung nach einem der vorhergehenden Ansprüche,
   **dadurch gekennzeichnet,**

daß in der Zelle (Z) oberhalb der Durchlaufbahn (D) mindestens eine obere Elektrode (Eo) und unterhalb der Durchlaufbahn (D) mindestens eine untere Elektrode (Eu) angeordnet sind.

8. Einrichtung nach einem der vorhergehenden Ansprüche,
   **dadurch gekennzeichnet,**
   daß der Kontaktiertrieb (K) zur Bildung der Transporteinrichtung angetrieben ist.

9. Einrichtung nach einem der vorhergehenden Ansprüche,
   **dadurch gekennzeichnet,**
   daß zu beiden Seiten der Durchlaufbahn (D) Kontaktiertriebe (K) angeordnet sind.

10. Einrichtung nach einem der vorhergehenden Ansprüche,
    **dadurch gekennzeichnet,**
    daß der Kontaktiertrieb (K) durch ein Metallband (M) oder ein Metallseil gebildet ist.

11. Einrichtung nach einem der vorhergehenden Ansprüche,
    **dadurch gekennzeichnet,**
    daß der Kontaktiertrieb (K) im Bereich der Zelle (Z) auf einer horizontal angeordneten Führung (F) gleitet.

12. Einrichtung nach einem der vorhergehenden Ansprüche,
    **dadurch gekennzeichnet,**
    daß in der Zelle (Z) mindestens ein Andruckorgan angeordnet ist, welches die durchlaufenden Werkstücke (W) gegen den Kontaktiertrieb (K) drückt.

13. Einrichtung nach Anspruch 12,
    **dadurch gekennzeichnet,**
    daß das Andruckorgan durch eine Andruckrolle (Ar) gebildet ist.

14. Einrichtung nach Anspruch 13,
    **dadurch gekennzeichnet,**
    daß die Andruckrolle (Ar) derart schräg angestellt ist, daß ein Durchbiegen dünner Werkstücke (W) verhindert wird.

15. Einrichtung nach Anspruch 13 oder 14,
    **dadurch gekennzeichnet,**
    daß die Andruckrolle (Ar) zur Bildung einer zusätzlichen Transporteinrichtung angetrieben ist.

16. Einrichtung nach einem der vorhergehenden Ansprüche,

**dadurch gekennzeichnet,**
daß das Kontaktorgan (Ko) durch eine drehbar gelagerte Kontaktrolle oder Kontaktwalze gebildet ist.

17. Einrichtung nach einem der vorhergehenden Ansprüche,
**dadurch gekennzeichnet,**
daß in mindestens einer Reinigungseinrichtung (R1) eine chemische Entlackung des Kontaktiertriebes (K) vorgenommen wird.

18. Einrichtung nach Anspruch 17,
**dadurch gekennzeichnet,**
daß die chemische Entlackung mit Hilfe von auf den Kontaktiertrieb gerichteten Sprühdüsen (Sd) vorgenommen wird.

19. Einrichtung nach Anspruch 17 oder 18,
**dadurch gekennzeichnet,**
daß der Reinigungseinrichtung (R1) für die chemische Entlackung mindestens eine Reinigungseinrichtung zum Spülen des Kontaktiertriebes (K) nachgeordnet ist.

20. Einrichtung nach Anspruch 19,
**dadurch gekennzeichnet,**
daß mindestens eine Reinigungseinrichtung zum Spülen des Kontaktiertriebes (K) mit Sprühdüsen (Sd) für das Spülmittel ausgerüstet ist.

21. Einrichtung nach einem der vorhergehenden Ansprüche,
**gekennzeichnet durch**
eine mäanderförmige Führung des Kontaktiertriebes (K) im Bereich der Reinigungseinrichtung (R1).

## FIG1

## FIG 2

Europäisches
Patentamt

EUROPÄISCHER RECHERCHENBERICHT

Nummer der Anmeldung

EP    92 10 9302

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| X | DE-A-1 577 956 (SCHILDE AG)<br><br>* Seite 4; Ansprüche 1,2,3 *<br>--- | 1,2,3,4, 6,7 | C25D13/22<br>C25D13/16 |
| A | GB-A-1 080 171 (PINCHIN, JOHNSON&ASSOCIATES LTD)<br>* Seite 2, Zeile 6 - Zeile 14 *<br>--- | | |
| A | FR-A-1 514 750 (IMPERIAL CHEMICAL INDUSTRIES LTD)<br>* Seite 2, rechte Spalte, Absatz 5 *<br>& -A-<br><br>----- | | |

**RECHERCHIERTE SACHGEBIETE (Int. Cl.5 )**

C25D

Der vorliegende Recherchenbericht wurde für alle Patentansprüche erstellt

| Recherchenort | Abschlußdatum der Recherche | Prüfer |
|---|---|---|
| DEN HAAG | 12 OKTOBER 1992 | NGUYEN THE NGHIEP N. |